# EUROPEAN PATENT SPECIFICATION

(11) **EP 3 128 560 B1**
(45) Date of publication and mention of the grant of the patent: **17.10.2018**
(21) Application number: 16182976.7
(22) Date of filing: 05.08.2016
(51) Int. Cl.: H01L 31/05

(54) **RIBBON FOR SOLAR CELL PANEL, METHOD OF MANUFACTURING THE SAME, AND SOLAR CELL PANEL**
BAND FÜR EIN SOLARZELLENPANEL, VERFAHREN ZU DESSEN HERSTELLUNG UND SOLARZELLENPANEL
RUBAN POUR PANNEAU DE CELLULE SOLAIRE, SON PROCÉDÉ DE FABRICATION ET PANNEAU DE CELLULE SOLAIRE

(30) Priority: 05.08.2015 KR 20150110700
(43) Date of publication of application: 08.02.2017
(73) Proprietor: LG ELECTRONICS INC., Yeongdeungpo-gu Seoul 07336 (KR)
(72) Inventor: Cho, Yunhui, 08592 Seoul (KR); Song, Wondoo, 08592 Seoul (KR); Park, Sanghwan, 08592 Seoul (KR)
(74) Representative: Katérle, Axel

(56) References cited:
- EP-A1- 1 981 091
- EP-A1- 2 472 597
- EP-A1- 2 835 835
- EP-A1- 2 897 177
- EP-A2- 1 271 660
- KR-A- 20150 083 748

## Description

### BACKGROUND OF THE INVENTION

### Field of the Invention

The present inventive concept relates to a ribbon for a solar cell panel, a method of manufacturing the same, and a solar cell panel, and more particularly, to a ribbon for a solar cell panel having an improved structure, a method of manufacturing the same, and a solar cell panel.

### Description of the Related Art

Recently, due to depletion of existing energy resources, such as oil and coal, interest in alternative sources of energy to replace the existing energy resources is increasing. Most of all, solar cells are popular next generation cells to convert sunlight into electrical energy.

A plurality of solar cells is connected to each other in series or in parallel using ribbons, and is manufactured into a module via packang, which is a process for protecting the solar cells. In order to improve properties of a solar cell panel, it is necessary to optimize the structure of ribbons.

EP 2 897 177 A1 discloses a wiring member including a conductor having a first face and a second face that is located opposite to the first face, a first layer provided on a first face of the conductor and containing a flux component and an anti-corrosive component, and a second layer provided on the second face of the conductor and including an adhesive.

### SUMMARY OF THE INVENTION

Therefore, the present inventive concept has been made in view of the above problems, and it is an object of the present inventive concept to provide a ribbon for a solar cell panel, which is capable of improving properties of the solar cell panel, a method of manufacturing the same, and a solar cell panel.

The invention (the present inventive concept) is defined by the subject-matter of the independent claims.

According to one aspect of the present inventive concept, the above and other objects can be accomplished by the provision of a ribbon for a solar cell panel including a ribbon body, an insulating layer disposed on at least one side over a longitudinal surface of at least the ribbon body, and a solder layer disposed throughout a portion excluding the insulating layer over the longitudinal surface of the ribbon body, the solder layer being disposed throughout at least a remaining side opposite to the one side.

According to another aspect of the present inventive concept, there is provided a method of manufacturing a bus-ribbon for a solar cell panel including forming an insulating layer, including a resin and a black material, on a portion of a ribbon body, and forming a solder layer throughout a remaining portion of the ribbon body excluding the insulating layer by immersing the ribbon body, having the insulating layer formed thereon, in a solder material.

According to a further aspect of the present inventive concept, there is provided a solar cell panel including a solar cell and a bus ribbon for connecting the solar cell to an external circuit. The bus ribbon includes a bus-ribbon body, an insulating layer disposed on at least a front surface of a longitudinal surface of at least the bus-ribbon body, and a solder layer disposed throughout a remaining portion excluding the insulating layer over the longitudinal surface of the bus-ribbon body, the solder layer being disposed throughout at least a back surface opposite to the front surface.

### BRIEF DESCRIPTION OF THE DRAWINGS

The above and other objects, features and other advantages of the present inventive concept will be more clearly understood from the following detailed description taken in conjunction with the accompanying drawings, in which:
FIG. 1 is an exploded perspective view illustrating a solar cell panel according to an embodiment of the present inventive concept;
FIG. 2 is a sectional view taken along line II-II of FIG. 1;
FIG. 3 is a sectional view illustrating a solar cell according to an embodiment of the present inventive concept;
FIG. 4 is a plan view of the solar cell illustrated in FIG. 3;
FIG. 5 is a perspective view schematically illustrating a bus-ribbon for a solar cell panel according to an embodiment of the present inventive concept;
FIG. 6 is a sectional view taken along line VI-VI of FIG. 5;
FIG. 7 is a schematic view for explaining a method of manufacturing a bus-ribbon according to the embodiment of the present inventive concept;
FIG. 8 is a photograph showing the wettability of a solder material with respect to a copper plate and an insulating layer;
FIG. 9 is a perspective view illustrating two neighboring solar cells and inter-ribbons in a solar cell panel according to an embodiment of the present inventive concept;
FIG. 10 is a sectional view illustrating the two neighboring solar cells and the inter-ribbons illustrated in FIG. 9;
FIG. 11 is a schematic plan view illustrating the spread inter-ribbon illustrated in FIG. 9;
FIG. 12 is a perspective view schematically illustrating a bus-ribbon for a solar cell panel according to another embodiment of the present inventive concept;
FIG. 13 is a sectional view taken along line VI-VI of FIG. 12;
FIG. 14 is a perspective view schematically illustrating a bus-ribbon for a solar cell panel according to a further embodiment of the present inventive concept; and
FIG. 15 is a sectional view taken along line VI-VI of FIG. 14.

### DETAILED DESCRIPTION OF THE EMBODIMENTS

Reference will now be made in detail to the embodiments of the present inventive concept, examples of which are illustrated in the accompanying drawings. However, it will be understood that the present inventive concept should not be limited to the embodiments and may be modified in various ways.

In the drawings, to clearly and briefly explain the present inventive concept, illustration of elements having no connection with the description is omitted, and the same or similar elements are designated by the same reference numerals throughout the specification. In addition, in the drawings, for a more clear explanation, the dimensions of elements, such as thickness, width, and the like, are exaggerated or reduced, and thus the thickness, width, and the like of the present inventive concept are not limited to the illustration of the drawings.

In the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this means that there are no intervening elements therebetween.

Hereinafter, a ribbon for a solar cell panel, a method of manufacturing the same, and a solar cell panel including the ribbon will be described in detail with reference to the accompanying drawings. The solar cell panel will first be described, and then the ribbon included in the solar cell panel and the method of manufacturing the ribbon will be described in detail.

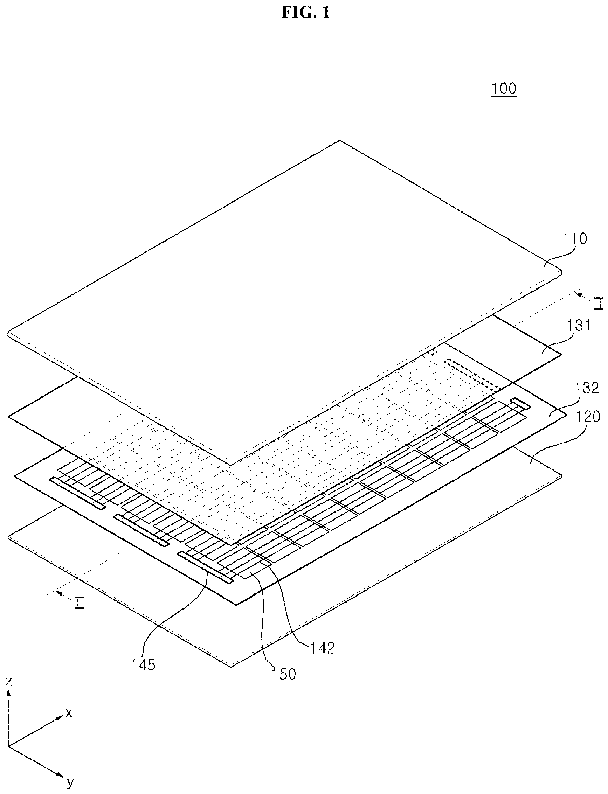

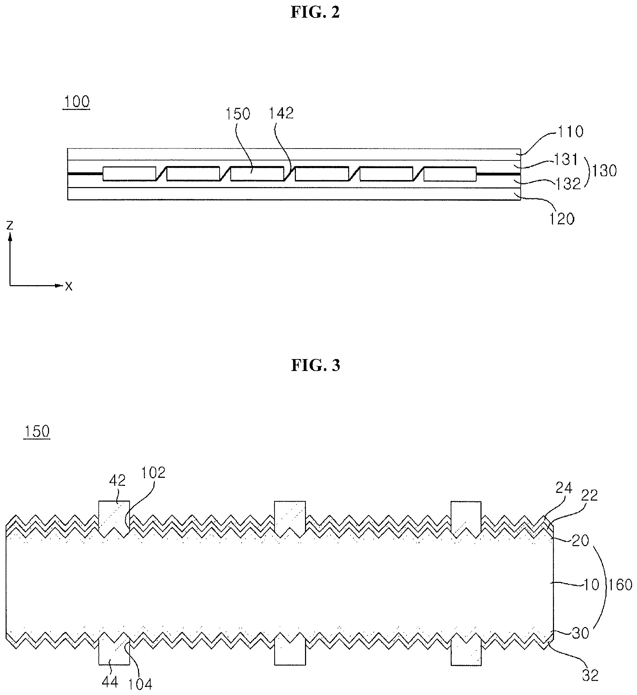

FIG. 1 is an exploded perspective view illustrating a solar cell panel according to an embodiment of the present inventive concept, and FIG. 2 is a sectional view taken along line II-II of FIG. 1.

Referring to FIGS. 1 and 2, the solar cell panel according to one embodiment of the present inventive concept, designated by reference numeral 100, includes a plurality of solar cells 150, inter-ribbons 142 for electrically connecting the respective neighboring solar cells 150 to each other, and bus-ribbons 145 for connecting the respective neighboring inter-ribbons 142 to each other, or connecting the inter-ribbons 142 to an external circuit (e.g. a circuit part, such as a terminal, junction box, bypass-diode, or inverter) or another solar cell panel 100. In this specification, the inter-ribbons 142 and the bus-ribbons 145 are collectively referred to as ribbons. Further, the solar cell panel 100 may include a sealing member 130 for surrounding and sealing the solar cells 150, a back substrate 120 disposed over the back surface of the solar cells 150 above the sealing member 130, and a front substrate 110 disposed over the front surface of the solar cells 150 above the sealing member 130. This will be described below in more detail.

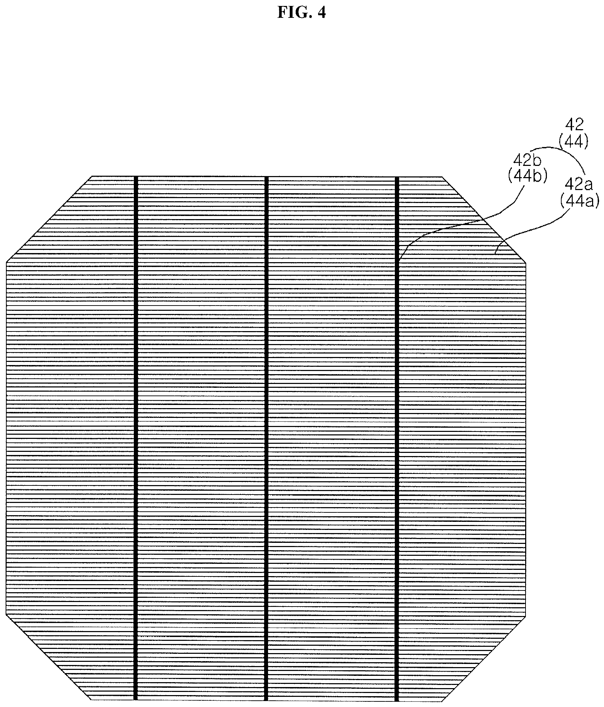

First, the solar cell 150 includes a photoelectric converter for converting sunlight into electrical energy, and an electrode electrically connected to the photoelectric converter. In the present embodiment, for example, a photoelectric converter including a semiconductor substrate (e.g. a silicon wafer) and a conductive area may be employed. One example of the solar cell 150 having the structure described above will be described below in detail with reference to FIGS. 3 and 4, and then the solar cell panel 100 will again be described in detail with reference to FIGS. 1 and 2.

FIG. 3 is a sectional view illustrating a solar cell according to an embodiment of the present inventive concept, and FIG. 4 is a plan view of the solar cell illustrated in FIG. 3. In FIG. 4, a semiconductor substrate 160 and first and second electrodes 42 and 44 are mainly illustrated.

Referring to FIG. 3, the solar cell 150 according to the present embodiment includes the semiconductor substrate 160 provided with a base area 10, which includes a dopant of a predetermined conductive type, conductive areas 20 and 30 including a first conductive area 20, which is doped with a dopant of a conductive type opposite to the conductive type of the base area 10, and a second conductive area 30, which is doped with a dopant of the same conductive type as the conductive type of the base area 10 at a higher dopant concentration than in the base area 10, and the electrodes 42 and 44 connected respectively to the first conductive area 20 and the second conductive area 30. Here, the terms "first", "second", etc. are simply used in order to distinguish elements from each other, and the present inventive concept is not limited thereto. In addition, the first electrode 42 is electrically connected to the first conductive area 20, and the second electrode 44 is electrically connected to the base area 10 or the second conductive area 30. In addition, for example, passivation films 22 and 32 and an anti-reflection film 24 may be formed. This will be described later in more detail.

The semiconductor substrate 160 includes the base area 10, and an area provided with the conductive areas 20 and 30.

In the present embodiment, the semiconductor substrate 160 may be formed of crystalline semiconductors. In one example, the semiconductor substrate 160 may be formed of monocrystalline or polycrystalline semiconductors (e.g. monocrystalline or polycrystalline silicon). More particularly, the semiconductor substrate 160 may be formed of monocrystalline semiconductors (e.g. a monocrystalline semiconductor wafer, and more specifically, a monocrystalline silicon wafer). When the semiconductor substrate 160 is included as described above, the solar cell 150 configures a crystalline silicon (monocrystalline silicon) solar cell. The solar cell 150, which includes the semiconductor substrate 10 formed of crystalline semiconductors (monocrystalline semiconductors), is based on the semiconductor substrate 160 having high crystallinity and thus low defects, and thus achieves excellent electrical properties.

In the present embodiment, the base area 10 and the conductive areas 20 and 30, which constitute the semiconductor substrate 160, may be defined by the dopants. For example, an area of the semiconductor substrate 160, which includes a first conductive dopant and thus is of a first conductive type, may be defined as the first conductive area 20, an area of the semiconductor substrate 160, which includes a second conductive dopant at a low doping concentration and thus is of a second conductive type, may be defined as the base area 10, and an area of the semiconductor substrate 160, which includes the second conductive dopant at a higher doping concentration than that in the base area 10 and thus is of the second conductive type, may be defined as the second conductive area 30. That is, the base area 10 and the conductive areas 20 and 30 are areas that include the crystalline structure of the semiconductor substrate 160 and are different in terms of the conductive type and the doping concentration thereof.

The present embodiment exemplifies that the conductive areas 20 and 30 are doped areas formed by doping the inside of the semiconductor substrate 160 with the dopants. However, the present inventive concept is not limited thereto. Accordingly, at least one of the first conductive area 20 and the second conductive area 30 may be configured as an amorphous, microcrystalline or polycrystalline semiconductor layer, which is a separate layer over the entire surface of the semiconductor substrate 160. Various other alterations are possible.

The first conductive dopant, included in the first conductive area 20, may be an n-type or p-type dopant, and the second conductive dopant, included in the base area 10 and the second conductive area 30, may be a p-type or n-type dopant, which is opposite to the first conductive type. The p-type dopant may be a group-Ill element, such as boron (B), aluminum (Al), gallium (Ga), or indium (In), and the n-type dopant may be a group-V element, such as phosphorus (P), arsenic (As), bismuth (Bi), or antimony (Sb). The second conductive dopant in the base area 10 and the second conductive dopant in the second conductive area 30 may be the same material, or may be different materials.

In one example, the first conductive area 20 may be of a p-type, and the base area 10 and the second conductive area 30 may be of an n-type. When light is emitted to a pn junction formed by the first conductive area 20 and the base area 10, electrons generated via photoelectric conversion move to the back surface of the semiconductor substrate 160 to thereby be collected by the second electrode 44, and holes move to the front surface of the semiconductor substrate 160 to thereby be collected by the first electrode 42. Thereby, electricity is generated. Because the holes, which move more slowly than the electrons, move to the front surface of the semiconductor substrate 160, rather than the back surface, the conversion efficiency may be improved. However, the present inventive concept is not limited thereto, and the base area 10 and the second conductive area 30 may be of a p-type, and the first conductive area 20 may be of an n-type.

The front surface and/or the back surface of the semiconductor substrate 160 may be subjected to texturing so as to have protrusions, which have slopes on the outer surface thereof (i.e. slopes on the front substrate 110 or the back substrate 120). At this time, the slopes of the protrusions may be specific faces of the semiconductor substrate 160 (e.g. (111) faces of silicon), and the protrusions may take the form of pyramids, the outer surface of which are (111) faces. When the protrusions are formed on, for example, the front surface of the semiconductor substrate 160 via texturing, the reflectance of light introduced through the front surface of the semiconductor substrate 160 may be reduced. Accordingly, the quantity of light, which reaches the pn junction formed on the interface of the base area 10 and the first conductive area 20 may be increased, which may minimize shading loss. However, the present embodiment is not limited thereto, and no protrusions may be formed on the front surface and the back surface of the semiconductor substrate 160 via texturing.

The first conductive area 20 may be formed on the front surface of the semiconductor substrate 160, and the second conductive area 30 may be formed on the back surface of the semiconductor substrate 160. As such, the first conductive area 20 and the second conductive area 30 may be located with the base area 10 interposed therebetween. However, the present inventive concept is not limited thereto, and the arrangement of the base area 10, the first conductive area 20 and the second conductive area 30 may be altered in various ways.

The first conductive area 20 may configure an emitter area, which forms a pn junction with the base area 10. The second conductive area 30 may configure a back-surface field area, which forms a back-surface field. The back-surface field area serves to prevent the loss of carriers due to recombination on the surface of the semiconductor substrate 160 (more accurately, the back surface of the semiconductor substrate 160).

The present embodiment exemplifies that the first and second conductive areas 20 and 30 have a homogeneous structure having a uniform doping concentration. However, the present inventive concept is not limited thereto. Thus, in another embodiment, at least one of the first conductive area 20 and the second conductive area 30 may have a selective structure. In the selective structure, a portion of the conductive areas 20 and 30, located close to the electrodes 42 and 44, may have a high doping concentration and low resistance, and the remaining portion may have a low doping concentration and high resistance. In another embodiment, the second conductive area 30 may have a local structure. In the local structure, the second conductive area 30 may be locally formed so as to correspond to a portion in which the second electrode 44 is formed.

Insulation films, such as the passivation films 22 and 32 and the anti-reflection film 24, may be formed over the semiconductor substrate 160. These insulation films may be configured as undoped insulation films having no dopant.

More specifically, the passivation film 22 may be formed over (e.g. in contact with) the front surface of the semiconductor substrate 160, more accurately, over the first conductive area 20 formed on the semiconductor substrate 160, and the anti-reflection film 24 may be formed over (e.g. in contact with) the passivation film 22. In addition, the passivation film 32 may be formed over the back surface of the semiconductor substrate 160, more accurately, over the second conductive area 30 formed on the semiconductor substrate 160.

The passivation film 22 and the anti-reflection film 24 may substantially be formed throughout the front surface of the semiconductor substrate 160 excluding a portion corresponding to the first electrode 42 (more accurately, a portion provided with a first opening 102). Similarly, the passivation film 32 may substantially be formed throughout the back surface of the semiconductor substrate 160 excluding a portion corresponding to the second electrode 42 (more accurately, a portion provided with a second opening 104).

The passivation films 22 and 32 come into contact with the first or second conductive areas 20 or 30 for passivation of defects present in the surface or the bulk of the conductive areas 20 and 30. As such, it is possible to increase the open-circuit voltage Voc of the solar cell 150 by removing recombination sites of minority carriers. The anti-reflection film 24 reduces the reflectance of light introduced into the front surface of the semiconductor substrate 160. This may increase the quantity of light, which reaches the pn junction formed on the interface of the base area 10 and the first conductive area 20. Thereby, the short-circuit current Isc of the solar cell 150 may be increased. In conclusion, the passivation films 22 and 32 and the anti-reflection film 24 may increase the open-circuit voltage and the short-circuit current of the solar cell 150, thereby improving the efficiency of the solar cell 150.

In one example, the passivation films 22 and 32 or the anti-reflection film 24 may include a single film or multiple films in the form of a combination of two or more films selected from the group consisting of a silicon nitride film, silicon nitride film containing hydrogen, silicon oxide film, silicon oxide nitride film, aluminum oxide film, MgF₂, ZnS, TiO₂, and CeO₂. In one example, the passivation films 22 and 32 may include a silicon oxide film or silicon nitride film having a fixed positive charge when the conductive areas 20 and 30 are of an n-type, and may include an aluminum oxide film having a fixed negative charge when the conductive areas 20 and 30 are of a p-type. In one example, the anti-reflection film 24 may include a silicon nitride.

However, the present inventive concept is not limited thereto, and the passivation films 22 and 32 and the anti-reflection film 24 may include various other materials. In addition, the stacking structure of the insulation films over the front surface and/or the back surface of the semiconductor substrate 160 may be altered in various ways. For example, the insulation films may be stacked one above another in a stacking sequence different from the above-described stacking sequence. Alternatively, at least one of the passivation films 22 and 32 and the anti-reflection film 24 may be omitted, or other insulation films excluding the passivation films 22 and 32 and the anti-reflection film 24 may be provided. Various other alterations are possible.

The first electrode 42 is electrically connected to the first conductive area 20 through the first opening 102, which is formed in the insulation films disposed on the front surface of the semiconductor substrate 160 (e.g. the passivation film 22 and the anti-reflection film 24). The second electrode 44 is electrically connected to the second conductive area 30 through the second opening 104, which is formed in the insulation film disposed on the back surface of the semiconductor substrate 160 (e.g. the passivation film 32). In one example, the first electrode 42 may come into contact with the first conductive area 20, and the second electrode 44 may come into contact with the second conductive area 30.

The first and second electrodes 42 and 44 may be formed of various materials (e.g. metal materials) and may have various shapes.

Referring to FIG. 4, the first and second electrodes 42 and 44 may include a plurality of finger electrodes 42a and 44a spaced apart from one another at a constant pitch. While FIG. 4 illustrates that the finger electrodes 42a and 44a are parallel to one another and are parallel to the edge of the semiconductor substrate 160, the present inventive concept is not limited thereto. In addition, the first and second electrodes 42 and 44 may include bus-bar electrodes 42b and 44b, which are formed in a direction crossing the finger electrodes 42a and 44a so as to interconnect the finger electrodes 42a and 44a. Only one bus-bar electrode 42b or 44b may be provided, or a plurality of bus-bar electrodes 42b or 44b may be arranged at a larger pitch than the pitch of the finger electrodes 42a and 44a as illustrated in FIG. 4. At this time, although the width of the bus-bar electrodes 42b and 44b may be larger than the width of the finger electrodes 42a and 44a, the present inventive concept is not limited thereto. Accordingly, the width of the bus-bar electrodes 42b and 44b may be equal to or less than the width of the finger electrodes 42a and 44a.

When viewing the cross section, both the finger electrode 42a and the bus-bar electrode 42b of the first electrode 42 may be formed so as to penetrate the passivation film 22 and the anti-reflection film 24. That is, the opening 102 may be formed so as to correspond to both the finger electrode 42a and the bus-bar electrode 42b of the first electrode 42. In addition, both the finger electrode 44a and the bus-bar electrode 44b of the second electrode 44 may be formed so as to penetrate the passivation film 32. That is, the opening 104 may be formed so as to correspond to both the finger electrode 44a and the bus-bar electrode 44b of the second electrode 44. However, the present inventive concept is not limited thereto. In another example, the finger electrode 42a of the first electrode 42 may be formed so as to penetrate the passivation film 22 and the anti-reflection film 24, and the bus-bar electrode 42b may be formed over the passivation film 22 and the anti-reflection film 24. In addition, the finger electrode 44a of the second electrode 44 may be formed so as to penetrate the passivation film 32, and the bus-bar electrode 44b may be formed over the passivation film 32.

In the present embodiment, the first and second electrodes 42 and 44 of the solar cell 150 have a given pattern so that the solar cell 150 has a bi-facial structure to allow light to be introduced into the front surface and the back surface of the semiconductor substrate 160. As such, the quantity of light for use in the solar cell 150 may be increased, which may contribute to improvement in the efficiency of the solar cell 150.

FIG. 4 illustrates that the first electrode 42 and the second electrode 44 have the same shape. However, the present inventive concept is not limited thereto, and for example, the widths and pitches of the finger electrodes 42a and the bus-bar electrodes 42b of the first electrode 42 may be different from the widths and pitches of the finger electrodes 44a and the bus-bar electrodes 44b of the second electrode 44. In addition, the first electrode 42 and the second electrode 44 may have different shapes, and various other alterations are possible.

One example of the solar cell 150 has been described above with reference to FIGS. 3 and 4. However, the present inventive concept is not limited thereto, and for example, the structure and type of the solar cell 150 may be altered in various ways. In one example, the solar cell 150 may employ a photoelectric converter having various structures using, for example, compound semiconductors or dye sensitized materials.

Referring again to FIGS. 1 and 2, the solar cell panel 100 may include the multiple solar cells 150, and the solar cells 150 may be electrically interconnected in series and/or in parallel by the inter-ribbons 142. Specifically, the inter-ribbon 142 may interconnect the first electrode (see reference numeral 42 in FIGS. 3 and 4) formed on the front surface of one solar cell 150 and the second electrode (see reference numeral 44 in FIGS. 3 and 4) formed on the back surface of another adjacent solar cell 150 via tabbing. Tabbing may be performed by applying flux to the electrodes 42 and 44 of the solar cells 150, positioning the inter-ribbon 142 on the electrodes 42 and 44 to which the flux has been applied, and performing firing. The flux is used to remove an oxide film that prevents soldering, and is not essentially included.

Alternatively, after a conductive film or paste is attached between the solar cell 150 and the inter-ribbon 142, the multiple solar cells 150 may be interconnected in series or in parallel via thermal compression. The conductive film or paste may be formed by dispersing conductive particles, which are formed of, for example, highly conductive gold, silver, nickel or copper, in a film formed of, for example, epoxy resin, acryl resin, polyimide resin, or polycarbonate resin. When heat and pressure are applied to the conductive film, the conductive particles are exposed out of the film, and the solar cell 150 and the inter-ribbon 142 may be electrically connected to each other via the exposed conductive particles. In the case where the multiple solar cells 150 are connected to one another by the conductive film so as to constitute a module, a process temperature may be reduced, which may prevent bending of the solar cell 150.

In addition, the bus ribbons 145 may connect the solar cells 150 interconnected by the inter-ribbon 142 to form a single row (i.e. a solar cell string) to another solar cell string or an external circuit. In one example, the bus ribbons 145 may be connected to an external circuit, such as, for example, a junction box, which collects electricity generated by the solar cells 150 and prevents backflow of electricity.

Each bus ribbon 145 may include a portion, which is provided on the end of the solar cell string in a single row form in a direction crossing the solar cell string. The portion of the bus ribbon 145, provided on the end of the solar cell string in a direction crossing the solar cell string, is not superposed on the solar cells 150, and therefore, is perceivable from the outside, rather than being hidden by the solar cells 150. In the present embodiment, the bus ribbon 145 may be black in at least the portion thereof, which is not hidden by the solar cells 150 and is perceivable from the outside. This will be described later in more detail. FIG. 1 illustrates that the bus ribbons 145 interconnect alternate ends of the solar cell strings. However, this is simply given by way of example, and for example, the connection structure of the bus ribbons 145 and the ends of the solar cell strings may be altered in various ways.

However, the present inventive concept is not limited thereto, and for example, the connection structure between the solar cells 150 and the connection structure between the solar cells and the external circuit may be altered in various ways.

The sealing member 130 may include a first sealing member 131 disposed on the front surface of the solar cells 150 and a second sealing member 132 disposed on the back surface of the solar cells 150. The first sealing member 131 and the second sealing member 132 prevent the introduction of moisture and oxygen, and realize a chemical bond between respective elements of the solar cell panel 100. The first and second sealing members 131 and 132 may be formed of an insulation material having light-transmissive and adhesive properties. In one example, the first sealing member 131 and the second sealing member 132 may be formed of ethylene vinyl acetate (EVA) copolymer resin, polyvinyl butyral, silicone resin, ester-based resin, or olefin-based resin. Through, for example, a lamination process using the first and second sealing members 131 and 132, the back substrate 120, the second sealing member 132, the solar cells 150, the first sealing member 131, and the front substrate 110 may be integrated with one another so as to construct the solar cell panel 100.

The front substrate 110 is disposed on the first sealing member 131 and configures the front surface of the solar cell panel 100. The back substrate 120 is disposed on the second sealing member 132 and configures the back surface of the solar cell panel 100. Each of the front substrate 110 and the back substrate 120 may be formed of an insulation material capable of protecting the solar cells 150 from external shocks, moisture, ultraviolet light, and the like. In addition, the front substrate 110 may be formed of a light-transmitting material capable of transmitting light, and the back substrate 120 may be configured as a back sheet formed of a light-transmitting material, a material not transmitting light, or a material reflecting light. In one example, the front substrate 110 may be configured as a glass substrate, and the back substrate 120 may be configured as a back sheet, which is of a Tedlar/PET/Tedlar (TPT) type, or includes a polyvinylidene fluoride (PVDF) resin layer formed on at least one surface of a base film (e.g. a polyethyleneterephthlate (PET) film). In the present embodiment, in order to achieve the aesthetically pleasing appearance, for example, the back substrate 120 may be configured as a black back sheet, which is black or gray black.

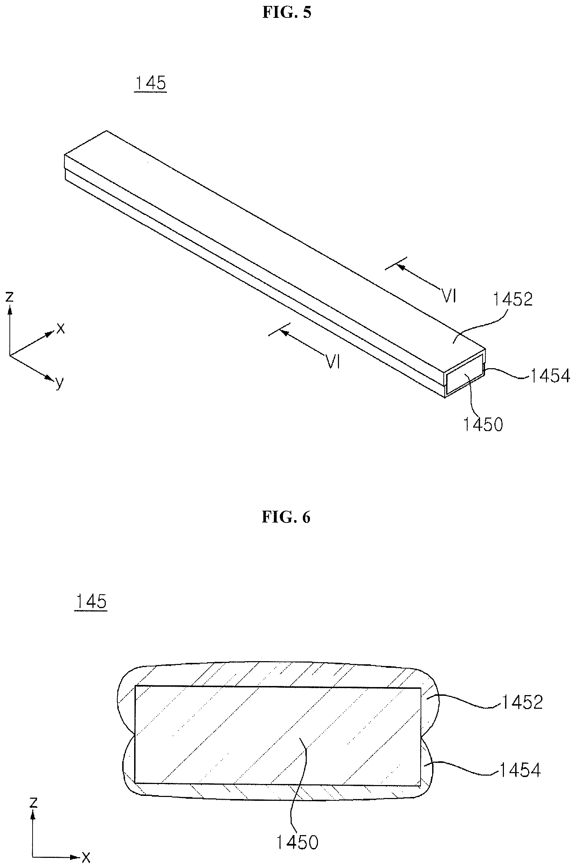

The above-described bus ribbon 145 and the method of manufacturing the same will be described in more detail with reference to FIGS. 5 to 8.

FIG. 5 is a perspective view schematically illustrating a bus-ribbon for a solar cell panel according to an embodiment of the present inventive concept, and FIG. 6 is a sectional view taken along line VI-VI of FIG. 5.

Referring to FIGS. 5 and 6, one end of the bus ribbon 145 is connected to the inter-ribbon 142, which is located on the end of the solar cell string connected by the inter-ribbon 142 so as to form a single row, or is connected to the solar cell 150 located on the end of the solar cell string. In addition, at least a portion of the bus ribbon 145 penetrates the second sealing member 132 and the other end of the bus ribbon 145 is connected to an external circuit. A portion of the bus ribbon 145, formed in a direction crossing the solar cell string, may be located so as not to be superposed on the solar cell 150, and thus may be located so as to be perceivable from the front side.

At this time, the bus ribbon 145 includes a bus-ribbon body 1450, a black layer (or an insulating layer) 1452 disposed on at least one side over the longitudinal surfaces (i.e. the xy surface and the yz surface) of the bus-ribbon body 1450, and a solder layer 1454 disposed throughout the remaining portion over the longitudinal surfaces of the bus-ribbon body 1450 excluding the black layer 1452. At this time, the solder layer 1454 is disposed throughout at least the other side, which is opposite to the aforementioned one side.

For reference, the black layer 1452 and/or the solder layer 1454 may be provided, or may not be provided on both longitudinal end surfaces of the bus-ribbon body 1450 (i.e. the xz surface in FIG. 5). That is, in the case where the black layer 1452 and the solder layer 1454 are formed in the state in which the bus-ribbon body 1450 is cut to a desired length, the black layer 1452 and/or the solder layer 1454 may also be provided on both the longitudinal end surfaces of the bus-ribbon body 1450. In the case where the black layer 1452 and the solder layer 1454 are formed on the bus-ribbon body 1450, which is longer than a desired length, and thereafter, the bus-ribbon body 1450 is cut to the desired length, the black layer 1452 and/or the solder layer 1454 may be located on only one end surface of the bus-ribbon body 1450, or may not be located on both the end surfaces.

The bus-ribbon body 1450 includes a conductive material (e.g. a metal), and occupies the largest volume in the bus ribbon 145, thus substantially serving as an electrical connection portion. The bus-ribbon body 1450 may include a material having excellent electrical conductivity (e.g. a metal). For example, the bus-ribbon body 1450 may include any of various metals, such as copper, silver or gold, as a main component (i.e. a component included in an amount of 50 wt% or more, specifically, 90 wt% or more, more specifically, 99 wt% or more). In particular, when the bus-ribbon body 1450 includes copper as a main component, it may achieve excellent electrical conductivity and physical properties while having low material costs. In addition, the bus-ribbon body 1450 may have high reflectance attributable to the material described above.

In one example, the bus-ribbon body 1450 may have a thickness ranging from 1 *µ*m to 1000*µ*m. When the thickness of the bus-ribbon body 1450 is below 1*µ*m, the bus-ribbon body 1450 may have low electrical conductivity. When the thickness of the bus-ribbon body 1450 exceeds 1000*µ*m, the material costs of the bus-ribbon body 1450 may be increased. However, the present inventive concept is not limited thereto, and the thickness of the bus-ribbon body 1450 may have any of various values depending on, for example, the width and material of the bus-ribbon body 1450, and may range from 200*µ*m to 450*µ*m.

In addition, the black layer 1452 may be disposed on one side over the longitudinal surfaces of the bus-ribbon body 1450. In particular, the black layer 1452 is disposed on the front surface or the surface opposite to the front surface among the longitudinal surfaces of the bus-ribbon body 1450. As such, in the state in which the bus ribbon 145 is disposed on the solar cell panel 100, the black layer 1452 may be located close to the front substrate 110 and the first sealing member 131, and more specifically, may be located between the bus-ribbon body 1450 and the first sealing member 131.

Because the bus-ribbon body 1450 or the solder layer 1454 of the bus ribbon 1450 is exposed to the front side when the black layer 1452 is not provided, light may be reflected by the bus-ribbon body 1450 or the solder layer 1454. Thereby, the user may perceive the form of the bus-ribbon body 1450. In particular, in the case where the back substrate 120 is black in order to achieve an aesthetically improved appearance, the reflection of light may occur only in the portion at which the bus ribbon 145 is located when the black layer 1452 is not provided unlike the present embodiment, which causes the bus ribbon 145 to be easily perceived. This may greatly deteriorate the appearance of the back substrate 120.

On the other hand, in the present embodiment, the black layer 1452 may be disposed on the front surface of the bus-ribbon body 1450 in order to prevent the bus ribbon 145 from being perceived from the front side. Thereby, it is possible to prevent the appearance of the solar cell panel 100 from being deteriorated by the bus ribbon 145. In addition, because the black layer 1452 includes a resin as a main component (i.e. a component included in an amount of 50 wt% or more), and thus has an insulation property, the solar cell panel 100 may achieve improved insulation in the thickness direction thereof.

At this time, the black layer 1452 may be formed so as to cover the entire front surface of the bus-ribbon body 1450. This may effectively prevent the bus ribbon 145 from being perceived from the outside. In addition, one surface of the black layer 1452 may come into contact with the bus-ribbon body 1450, and no separate layer may be provided on the other surface of the black layer 1452 so that the other surface of the black layer 1452 configures the outer surface of the bus ribbon 145. In this way, the structure of the bus ribbon 145 may be simplified, and the black layer 1452 may be formed via a simplified process, such as, for example, dispensing. In addition, no layer is provided on the surface of the bus-ribbon body 1450, located close to the black layer 1452, which may prevent any problem caused by the stacking of another layer. For example, when the solder layer 1454 is interposed between the bus-ribbon body 1450 and the black layer 1452, the black layer 1452 may not be stably formed, and may be damaged or broken due to, for example, a difference in thermal properties between the black layer 1452 and the solder layer 1454. In addition, when the solder layer 1454, which includes, for example, a metal, is disposed over the black layer 1452, the effect of the black layer 1452 for preventing the bus ribbon 145 from being perceived from the outside may not be achieved. However, the present inventive concept is not limited thereto. Thus, a transparent or black layer, which does not negate the effect of the black layer 1452, may be disposed over the other surface of the black layer 1452.

Here, the black layer 1452 may be disposed on the entire front surface and either side surface (i.e. the zy surfaces in FIG. 5), which connects the front surface and the back surface to each other, among the longitudinal surfaces of the bus-ribbon body 1450. In one example, the black layer 1452 may be disposed on a portion of the side surface, which is located close to the front surface. This is because the black layer 1452 may be formed on a portion of the side surface, located close to the front surface, while the black layer 1452 is formed on the front surface in a black layer forming process. In one example, the area of the black layer 1452 may range from 40% to 60% of the area of the side surface of the bus-ribbon body 1450. However, the present inventive concept is not limited thereto, and various alterations are possible.

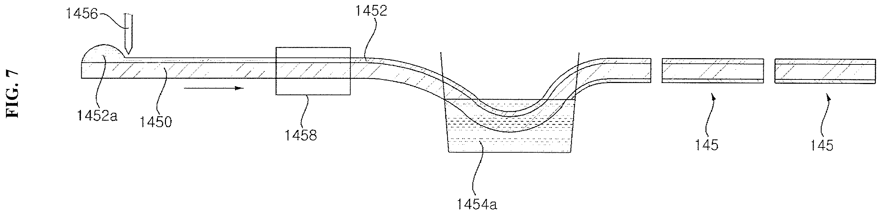

In one example, the other surface (i.e. the outer surface) of the black layer 1452 may be a curved surface, the entirety of which has a rounded shape. That is, when viewing the cross section of the bus ribbon 145, the other entire surface of the black layer 1452 may be rounded. This is because the black layer 1452 is formed by applying and then curing ink (see reference numeral 1452a in FIG. 7). However, the present inventive concept is not limited thereto, and the cross section of the black layer 1452 may have any of various shapes.

The black layer 1452 needs to be black so as not to expose the bus-ribbon body 1450 to the outside. Here, "black" may refer to dark black, gray, etc. In one example, "black" may have "L" ranging from 0 to 70, "a*" ranging from -30 to +30, and "b*" ranging from -30 to +30 based on the Commission International de l'Eclairage (CIE) color coordinates.

In the present embodiment, the black layer 1452 may be formed by dispensing and curing the ink 1452a, which includes a black material and a resin.

The resin may be selected from various materials, and may include a thermosetting organic binder, which may be cured by heat. As such, after the ink 1452a is dispensed, the ink 1452a may be easily cured when heat is applied thereto. In one example, an acryl-based binder may be used as the thermosetting organic binder. The acryl-based binder has low price and is readily available, and may be attached to the bus-ribbon body 1450 with strong adhesive force. Alternatively, the resin may be ethylenevinyl acetate (EVA), olefin, or the like. However, the present inventive concept is not limited thereto, and various other materials may be used as the resin in the black layer 1452.

The black material may be any of various black materials, and for example, may be carbon black. Carbon black has low price, and has a nano-scale particle diameter ranging from 100nm to 200nm, thus having a larger surface-area than the volume thereof, which may secure excellent attachment between carbon black and the resin so that carbon black is evenly dispersed in the resin. In this way, carbon black may be evenly distributed in the black layer 1452 so that the black layer 1452 has an even color. In addition, because carbon black may achieve excellent electrical insulation, the black layer 1452 may achieve improved insulation. In addition, carbon black has very low reactivity with a solder material, thus preventing the solder layer 1454 from being formed in the portion in which the black layer 1452 is formed. However, the present inventive concept is not limited thereto, and various other materials may be used as the black material.

In one example, the black material may be included in an amount of 1 to 50 parts by weight with respect to 100 parts by weight of the black layer 1452. When the black material is included below 1 part by weight, the black layer 1452 may not sufficiently prevent the bus ribbon 145 from being perceived. When the black material exceeds 50 parts by weight, the amount of resin may be insufficient, causing deterioration in the physical properties of the black layer 1452. In one example, when the black material is included in an amount of 1 to 30 parts by weight (more specifically, 3 to 10 parts by weight), the black layer 1452 may sufficiently exert the effect thereof and ensure further improved physical properties thereof. However, the present inventive concept is not limited thereto, and the content of the black material may have a different value.

The ink 1452a may include other materials except for the resin and the black material. The other materials and composition of the ink 1452a, and the detailed process of forming the black layer 1452 using the ink 1452a will be described later in more detail with reference to FIG. 7.

In one example, the thickness of the black layer 1452 may range from 1*µ*m to 100*µ*m. When the thickness of the black layer 1452 is below 1*µ*m, the black layer 1452 may not sufficiently exert the effect thereof. When the thickness of the black layer 1452 exceeds 100*µ*m, for example, the material costs and the process time of the black layer 1452 may be increased. However, the present inventive concept is not limited thereto, and the thickness of the black layer 1452 may have various values. The thickness of the black layer 1452 may range from 20*µ*m to 60*µ*m.

In addition, the solder layer 1454 may be formed on a portion of the longitudinal surfaces of the bus-ribbon body 1450 excluding the portion in which the black layer 1452 is formed. The solder layer 1454 may be disposed throughout at least the other side (i.e. the back surface), which is opposite to the aforementioned one side (i.e. the front surface) on which the black layer 1452 is disposed, on the longitudinal surfaces of the bus-ribbon body 1450. The other side of the bus-ribbon body 1450 is connected to the inter-ribbon 142 or the solar cell 150 (more specifically, the electrodes 42 and 44 of the solar cell 150), and serves to improve electrical connection owing to the solder layer 1454. In addition, the other side of the bus-ribbon body 1450 is not exposed to the front side, and therefore, does not require the black layer 1452.

In the present embodiment, the bus-ribbon body 1450, having the black layer 1452 formed on a portion thereof, is immersed in a solder material (see reference numeral 1454a in FIG. 7), which is a constituent material of the solder layer 1454, whereby the solder layer 1454 is formed. At this time, the wettability of the solder material 1454a with respect to the black layer 1452 is lower than that with respect to the bus-ribbon body 1450, such that the solder layer 1454 is not formed in the portion in which the black layer 1452 is located, but is formed in the portion in which no black layer 1452 is present. This will be described later in more detail with reference to FIG. 7.

In the state in which the bus ribbon 145 is mounted in the solar cell panel 100, the solder layer 1454 is located between the bus-ribbon body 1450 and the inter-ribbon 142, and serves to physically fix and electrically connect the bus ribbon 145 to the inter-ribbon 142. The solder layer 1454 may be formed of a material, which may be physically fixed and electrically connected to the inter-ribbon 142. For example, the solder layer 1454 may include tin (Sn), and may further include various other metals. In one example, the solder layer 1454 may include tin in an amount of 30 to 100 wt%, and may further include lead (Pb) in an amount of 0 to 50 wt%, silver (Ag) in an amount of 0 to 20 wt%, bismuth (Bi) in an amount of 0 to 60 wt%, zinc (Zn) in an amount of 0 to 60 wt%, and copper (Cu) in an amount of 0 to 50 wt%. While this composition of the solder layer 1454 is limited to the range in which the solder layer 1454 may attach the bus-ribbon body 1450 and the inter-ribbon 142 to each other with excellent adhesive force, the present inventive concept is not limited thereto. Accordingly, the composition of the solder layer 1454 may be changed in various ways.

At this time, because the black layer 1452 is disposed throughout the front surface among the longitudinal surfaces of the bus-ribbon body 1450 as described above, the solder layer 1454 may be disposed on the back surface among the longitudinal surfaces of the bus-ribbon body 1450. In addition, the solder layer 1454 may be formed on a portion of either side surface, among the longitudinal surfaces of the bus-ribbon body 1450, in which the black layer 1452 is not formed, i.e. a portion close to the back surface. Thereby, both the solder layer 1452 and the black layer 1452 are present in different portions on either side surface of the bus-ribbon body 1450 so as to cover the entire side surface. In one example, the area of the solder layer 1454 may range from 40% to 60% of the area of either side surface of the bus-ribbon body 1450. However, the present inventive concept is not limited thereto, and various alterations are possible.

In one example, the outer surface of the solder layer 1454 may be a curved surface, which wholly has a rounded shape. That is, when viewing the cross section of the bus ribbon 145, the entire outer surface of the solder layer 1454 may be rounded. This is because the solder layer 1454 is formed by applying and drying the solder material 1454a, which has fluidity like the ink. However, the present inventive concept is not limited thereto, and the cross section of the solder layer 1454 may have various other shapes.

In addition, one surface of the solder layer 1454 may come into contact with the bus-ribbon body 1450, and the other surface of the solder layer 1454 may configure the outer surface of the bus-ribbon 145 because no separate layer is provided on the other surface of the solder layer 1454. Thereby, the surfaces of the solder layer 1454 and the black layer 1452, which are disposed to surround the entire surface of the bus-ribbon body 1450, configure the entire longitudinal outer surface of the bus-ribbon 145.

In this way, the structure of the bus ribbon 145 may be simplified, and the solder layer 1454 may be formed by a simplified process of immersing the bus-ribbon body 1450 having the black layer 1452 formed thereon. In addition, because no layer is provided on the surface of the bus-ribbon body 1450 close to the solder layer 1454, there may occur no problem caused by the stacking of other layers. For example, when a separate layer is provided between the bus-ribbon body 1450 and the solder layer 1454, the solder layer 1454 may not be stably formed. In addition, when a separate layer is provided over the solder layer 1454, adhesive force between the inter-ribbon 142 and the bus ribbon 145 may be deteriorated. However, the present inventive concept is not limited thereto. Accordingly, a separate layer may be provided between the bus-ribbon body 1450 and the solder layer 1454 in order to increase the adhesive force therebetween.

The thickness of the solder layer 1454 may be less than the thickness of the black layer 1452. This is because the black layer 1452 has a sufficient thickness so as to be seen in black. In one example, the thickness of the solder layer 1454 may range from 0.5*µ*m to 50*µ*m. When the thickness of the solder layer 1454 is below 0.5*µ*m, the solder layer 1454 may exert insufficient adhesive force. When the thickness of the solder layer 1454 exceeds 50*µ*m, for example, the material costs and the process time of the solder layer 1454 may be increased. However, the present inventive concept is not limited thereto, and the thickness of the solder layer 1454 may have various values. The thickness of the solder layer 1454 may range from 15*µ*m to 50*µ*m.

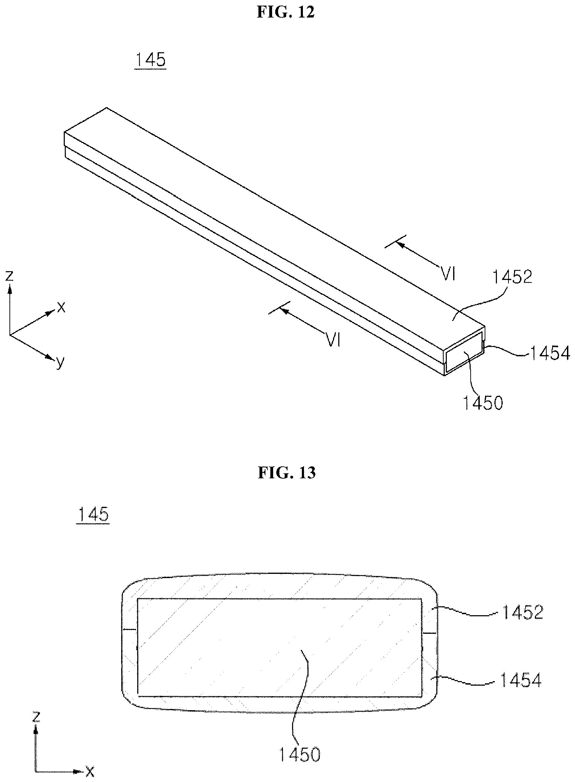

Next, a bus ribbon for a solar cell panel according to another embodiment of the present inventive concept will be described with reference to FIGS. 12 and 13.

FIG. 12 is a perspective view schematically illustrating a bus-ribbon for a solar cell panel according to another embodiment of the present inventive concept. FIG. 13 is a sectional view taken along line VI-VI of FIG. 12.

The bus ribbon for the solar cell panel according to the present embodiment has substantially the same configuration as the bus ribbon for the solar cell panel described above with reference to FIGS. 5 and 6, except for the arrangement of the black layer 1452 and the solder layer 1454 on either side surface of the bus-ribbon body 1450. Accordingly, the same reference numerals are used to designate the same constituent elements, and a repeated description thereof will be omitted.

Referring to FIGS. 12 and 13, the bus ribbon 145 includes the black layer 1452 and the solder layer 1454, which are disposed on the side surface of the bus-ribbon body 1450.

Specifically, the lower surface of the black layer 1452 and the upper surface of the solder layer 1454 may come into contact with each other on either side surface of the bus-ribbon body 1450. The profile of the side surface of the black layer 1452 and the profile of the side surface of the solder layer 1454 may be successively connected to each other, without being limited thereto. In addition, while FIG. 13 illustrates that the lower surface of the black layer 1452 and the upper surface of the solder layer 1454 completely come into contact with each other, the present inventive concept is not limited thereto. Accordingly, in the state in which the solder layer 1454 and the black layer 1452 are arranged on the side surface of the bus-ribbon body 1450, a portion of the lower surface of the black layer 1452 may come into contact with the upper surface of the solder layer 1454.

In the present embodiment, the black layer 1452 may stably cover the front surface of the bus-ribbon body 1450 because it extends to the side surface of the bus-ribbon body 1450. The black layer 1452, which covers the front surface of the bus ribbon 145, and the bus-ribbon body 1450 have a difference in wettability. That is, the black layer 1452 may not sufficiently cover the front surface of the bus-ribbon body 1450, or may expose the side surface of the bus-ribbon body 1450 because of a difference in wettability between a constituent material of the black layer 1452 and a constituent material of the bus-ribbon body 1450. Because the solder layer 1454 may be exposed at the front surface of the bus-ribbon body 1450 when the black layer 1452 does not sufficiently cover the front surface of the bus-ribbon body 1450, the external appearance of the solar cell panel 100 may be deteriorated. In addition, when the side surface is not sufficiently covered even if the front surface is sufficiently coated, the solder layer formed on the side surface is exposed at the front surface, causing deterioration in visibility.

Accordingly, in order to prevent deterioration in the quality of the external appearance of the solar cell panel 100, the black layer 1452 may extend to a certain portion of the side surface of the bus-ribbon body 1450.

The black layer 1452 may cover the range from 30% to 70% of the entire length of the side surface of the bus-ribbon body 1450. When the black layer 1452 covers the range from 30% to 70% of the entire length of the side surface of the bus-ribbon body 1450, the bus ribbon 145 may maintain stable adhesive force in the solar cell panel 100 and may prevent the solder layer 1454 from being exposed at the front surface of the bus-ribbon body 1450.

That is, when the black layer 1452 covers the range below 30% of the entire length of the side surface of the bus-ribbon body 1450, the solder layer 1454 may be exposed at the front surface of the bus-ribbon body 1450. When the black layer 1452 covers the range beyond 70% of the entire length of the side surface of the bus-ribbon body 1450, adhesion of the bus ribbon 145 may be problematic.

In the present embodiment, because the black layer 1452 extends to a certain portion of the side surface of the bus-ribbon body 1450, the black layer 1452 may maintain a more stabilized coating rate on the front surface of the bus-ribbon body 1450.

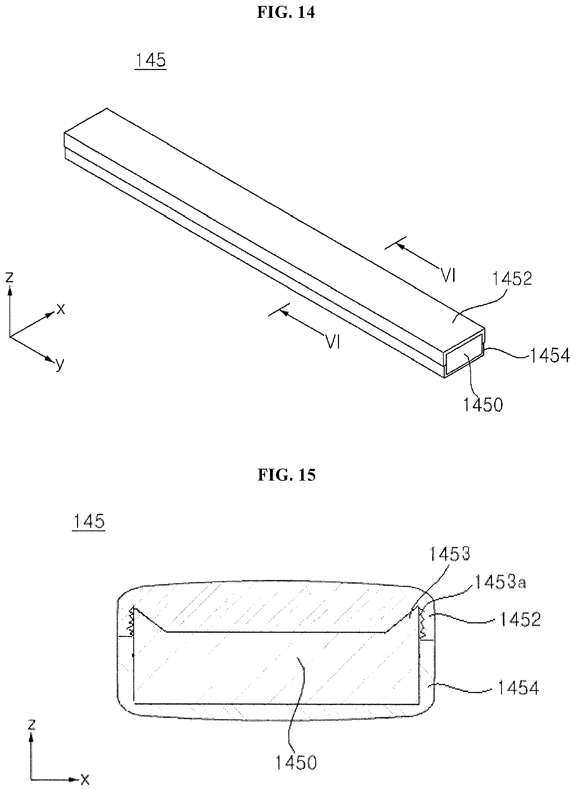

Subsequently, a bus ribbon for a solar cell panel according to an embodiment of the present inventive concept will be described with reference to FIGS. 14 and 15.

FIG. 14 is a perspective view schematically illustrating a bus-ribbon for a solar cell panel according to another embodiment of the present inventive concept. FIG. 15 is a sectional view taken along line VI-VI of FIG. 14.

The bus ribbon for the solar cell panel according to the present embodiment has substantially the same configuration compared to the bus ribbon for the solar cell panel described above with reference to FIGS. 12 and 13, except for the shape of the bus-ribbon body 1450. Thus, the same reference numerals are used to designate the same constituent elements, and a repeated description thereof will be omitted.

Referring to FIGS. 14 and 15, the bus ribbon 145 includes the black layer 1452 and the solder layer 1454, which are disposed on either side surface of the bus-ribbon body 1450. In addition, the bus-ribbon body 1450 may further include a protrusion 1453 protruding from the front surface of the bus-ribbon body 1450, and bosses 1453a formed on the side surface of the bus-ribbon body 1450 including the protrusion 1453. The bosses 1453a are formed on the edge of the longitudinal side surface of the bus ribbon 145, and protrude by a length of about 10 to 30*µ*m.

The protrusion 1453 and the bosses 1453a on the surface of the protrusion 1453 may be formed by cutting during manufacture of the bus-ribbon body 1450. That is, the protrusion 1453 and the bosses 1453a may be structures formed when a constituent material of the bus-ribbon body 1450 is stretched by physical shock applied to the bus-ribbon body 1450 while the bus-ribbon body 1450 is manufactured, without being limited thereto. At this time, the bosses refer to a region having an increased roughness compared to the other region of the bus ribbon. Accordingly, the protrusion 1453 and the bosses 1453a may be structures formed via an additional process after manufacture of the bus-ribbon body 1450.

In the present embodiment, the black layer 1452 may be formed on the front surface of the bus-ribbon body 1450 so as to come into contact with the inner side surface of the protrusion 1453, and may be formed on the side surface of the bus-ribbon body 1450 so as to be disposed on a region in which the bosses 1453a are formed. This may prevent deterioration in the coating rate of the black layer 1452 due to a difference in wettability between the black layer 1452 and the bus-ribbon body 1450. That is, because the protrusion 1453 serves as a dam on the front surface of the bus-ribbon body 1450, the black layer 1452 may be formed to a sufficient thickness on the front surface of the bus-ribbon body 1450. In addition, because the bosses 1453a provided on the side surface of the bus-ribbon body 1450 increase the surface area of the bus-ribbon body 1450, a constituent material of the black layer 1452 and the side surface of the bus-ribbon body 1450 may achieve an increased contact area, which allows adhesive force between the black layer 1452 and the bus-ribbon body 1450 to be stably maintained even if the constituent material of the black layer 1452 constricts during drying after it is applied.

Meanwhile, in order to secure stabilized adhesion of the black layer 1452 on the bus-ribbon body 1450, the surface tension of the constituent material of the black layer 1452 may be 20 to 30 dyne/cm, without being limited thereto. When the surface tension of the constituent material of the black layer 1452 is 20 to 30 dyne/cm, the black layer 1452 may achieve appropriate attachment force and coating rate.

In the present embodiment, because the bus-ribbon body 1450 includes the protrusion 1453 and/or the bosses 1453a, the attachment force and the coating rate of the black layer 1452 formed on the front surface and the side surface of the bus-ribbon body 1450 may be improved.

In addition, while the bus ribbon may be stepped from the solar cell or the inter-ribbon, thus exhibiting deteriorated attachment force when the protrusion of the bus ribbon faces the solar cell or the inter-ribbon, in the present inventive concept, the black layer is formed on the surface provided with the protrusion and the solder layer is formed on the opposite surface, which advantageously increases attachment force between the bus ribbon and the solar cell or the inter-ribbon.

Hereinafter, a method of manufacturing the bus ribbon 145 according to the embodiment will be described in detail with reference to FIG. 7. A detailed description of the above-described parts will be omitted below, and only different parts will be described below in detail.

FIG. 7 is a schematic view for explaining a method of manufacturing the bus-ribbon 145 according to the embodiment.

First, the black layer 1452, which includes a resin in a portion thereof, is formed on the bus-ribbon body 1450. At this time, the black layer 1452 may be formed by dispensing and curing the ink 1452a, which includes a resin and a black material.

More specifically, the ink 1452a may include a resin, a black material, a thermal curing agent, and other additives. The resin and the black material have been described above, and thus a repeated description thereof will be omitted. The thermal curing agent serves to facilitate curing when a thermosetting organic binder is cured by heat. The thermal curing agent may be single karyotype or 2 karyotype, and may include various materials that enable thermal curing. The other additives are not necessary, and for example, may include a dispersing agent. In addition, the ink 1452a may include various other materials.

In the case where the black layer 1452 is formed by applying and curing the ink 1452a as described above, the black layer 1452 having a desired pattern may be formed via an easy and simplified process. In addition, because the black layer 1452 includes the resin as a main component, the black layer 1452 may be firmly attached to the bus-ribbon body 1450 via drying thereof.

At this time, as illustrated in FIG. 7, after the ink 1452a is dispensed to one surface of the bus-ribbon body 1450 while the bus-ribbon body 1450 is moved in a given direction, the ink 1452a may pass through an air knife or blade 1456 so as to be applied to a constant thickness, and then may pass through a thermal dryer 1458. Thereby, the bus-ribbon body 1450, to which the ink 1452a for formation of the black layer 1452 has been dispensed, is dried and cured within the thermal dryer 1452, whereby the black layer 1452 is formed over at least the front surface of the bus-ribbon body 1450. As such, the black layer 1452 may be formed via a simplified process. At this time, the ink may also be applied to the surface of the bus ribbon having bosses in order to have a sufficient thickness and area so that the ink is applied to the side surface of the bus ribbon.

The process conditions in the thermal dryer 1458 are thermal curing process conditions required to thermally cure and dry the black layer 1452. In one example, the black layer 1452 may be formed by being maintained at a temperature ranging from 100°C to 200°C for 5 to 50 minutes. The black layer 1452 may be constantly and evenly cured within this range. However, the present inventive concept is not limited to this temperature and time.

At this time, because the ink is applied over a sufficient area in the entire process, the ink may also remain on the side surface of the bus ribbon even if it constricts after being dried.

Subsequently, the bus-ribbon body 1450, provided with the black layer 1452, is immersed in the solder material 1454a, which is used to form the solder layer 1454. Because the solder material 1454a has been heated to a higher temperature than room temperature, the solder material 1454a has certain fluidity, and thus is smoothly applied to the bus-ribbon body 1450. In one example, the solder material 1454a may be heated to a temperature ranging from 200°C to 300°C. This is because the solder material 1454a has sufficient fluidity and may be evenly applied at this temperature. However, the present inventive concept is not limited to the aforementioned temperature.

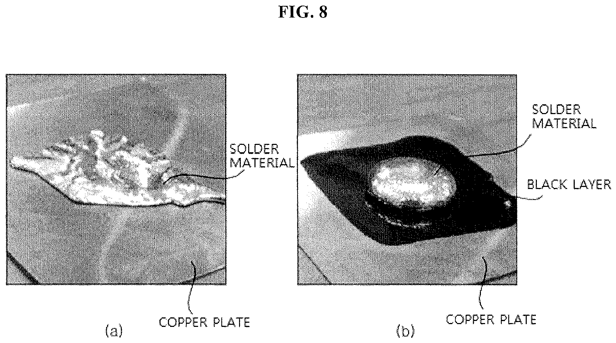

At this time, the solder material 1454a has high wettability to the bus-ribbon body 1450, which includes a metal as a main component, but has low wettability to the black layer 1452, which includes a resin as a main component. That is, the wettability of the solder material 1454a with respect to the black layer 1452 is less than the wettability of the solder material 1454a with respect to the bus-ribbon body 1450. Accordingly, as illustrated in (a) of FIG. 8, the solder material 1454a widely and evenly spreads over a material constituting the bus-ribbon body 1450 (e.g. a copper plate in (a) of FIG. 8). On the other hand, as illustrated in (b) of FIG. 8, it can be appreciated that the solder material 1454a is circularly condensed and does not spread over the black layer 1452.

Accordingly, the solder material 1454a may not be formed in the portion in which the black layer 1452 is formed, but may be formed throughout the portion in which the black layer 1452 is not formed. Thereby, the solder material 1454a may be evenly applied over the entire bus-ribbon body 1450 excluding the black layer 1452 via a simplified process.

The material, applied to the bus-ribbon body 1450 on which the black layer 1452 is not formed, forms the solder layer 1454 by being cooled. At this time, cooling may be performed via a separate cooling device, or may be naturally performed. Thereby, the solder layer 1454 may be evenly formed in the portion excluding the black layer 1452.

Subsequently, when the bus-ribbon body 1450, provided with the black layer 1452 and the solder layer 1454, is cut to a given length, manufacture of the bus-ribbon 145 may be completed.

According to the present embodiment, the black layer 1452 may be formed in a desired portion via an easy and simplified process of forming the black layer 1452 on the bus-ribbon body 1450 via dispensing and curing. Then, when the bus-ribbon body 1450, having the black layer 1452 formed thereon, is immersed in the solder material 1454a and then is cooled, the solder layer 1454 may be naturally formed on the entire portion excluding the black layer 1452 because of a difference in wettability between the portion in which the black layer 1452 is not formed and the portion in which the black layer 1452 is formed. In this way, the process of forming the solder layer 1454 may be simplified.

On the other hand, the solder layer 1454 has conventionally been formed over the entire surface of the bus-ribbon body 1450 by immersing the bus-ribbon body 1450, having no separate layer formed thereon, in the solder material 1454a. Because the solder layer 1454 is disposed on the front surface of the bus-ribbon body 1450, which is not used for connection of the inter-ribbon 142, material costs are increased, and it is impossible to prevent the bus ribbon 145 from being perceived from the outside. When a separate patterning process is used in order to form the black layer 1452 on the front surface of the bus-ribbon body 1450, which is not used for the connection of the inter-ribbon 142, and to form the solder layer 1454 on the entire portion excluding the black layer 1452, the process may be complicated. When the solder layer 1454 is formed via, for example, printing or dispensing, it may be difficult to evenly form the black layer 1452 and the solder layer 1454 on the entire surface of the bus-ribbon body 1450. Hence, when exposed to a high-humidity environment for a long time, corrosion may occur in the portion of the bus-ribbon body 1450 not covered with the black layer 1452 and/or the solder layer 1454.

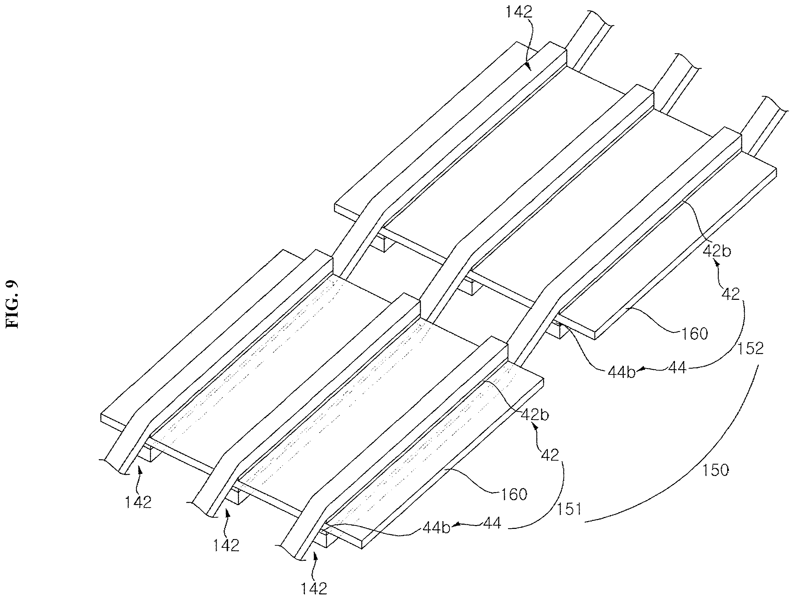

The above-described embodiment exemplifies that the bus ribbon 145 includes the bus-ribbon body 1450, and the solder layer 1454 and the black layer 1452 formed on the bus-ribbon body 1450. However, the present inventive concept is not limited thereto, and the inter-ribbon 142, which interconnects neighboring solar cells 150, may include an inter-ribbon body 1420, and a solder layer 1424 and a black layer 1422 formed on the inter-ribbon body 1420. This will be described below in detail with reference to FIGS. 9 to 11.

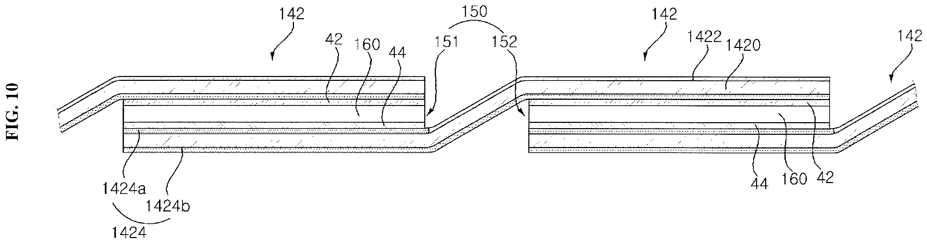

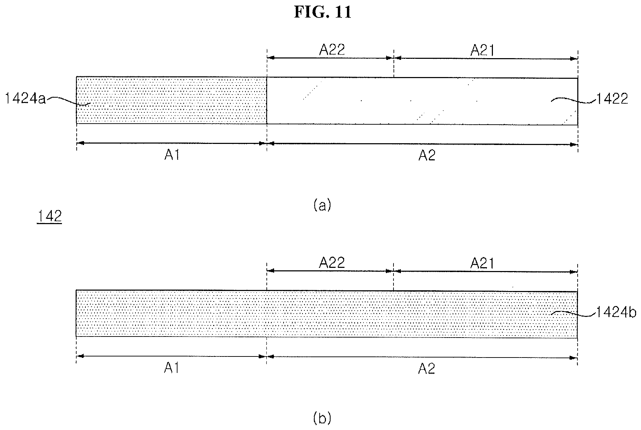

FIG. 9 is a perspective view illustrating two neighboring solar cells 150 and the inter-ribbons 142 in the solar cell panel 100 according to another embodiment of the present inventive concept, and FIG. 10 is a sectional view illustrating the two neighboring solar cells 150 and the inter-ribbons 142 illustrated in FIG. 9. For clear and simplified illustration, in FIG. 10, only the semiconductor substrate 160 and the first and second electrodes 42 and 44 are illustrated with relation to the solar cell 150. In addition, FIG. 11 is a schematic plan view illustrating the spread inter-ribbon 142 illustrated in FIG. 9. Here, (a) of FIG. 11 is a front plan view of the inter-ribbon 142, and (b) of FIG. 11 is a rear plan view of the inter-ribbon 142.

Referring to FIGS. 9 to 11, the solar cell panel 100 includes two neighboring solar cells 150 (i.e. a first solar cell 151 and a second solar cell 152).

In the present embodiment, the inter-ribbon 142 includes an inter-ribbon body 1420, which includes a conductive material (e.g. a metal) so as to electrically interconnect the neighboring solar cells 150, a black layer 1422 disposed on at least one side over the longitudinal surfaces of the inter-ribbon body 1420, and a solder layer 1424 provided between the inter-ribbon body 1420 and the electrodes 42 and 44 for electrically and physically connecting the inter-ribbon body 1420 and the electrodes 42 and 44 to each other. At this time, the solder layer 1424 is disposed on the entire portion of the longitudinal surfaces of the inter-ribbon body 1420 excluding the black layer 1422, and is disposed throughout at least the other side, which is opposite to the aforementioned one side.

The inter-ribbon body 1420 may be formed of a material having excellent electrical conductivity (e.g. a metal). For example, the inter-ribbon body 1420 may be formed of any of various metals, such as copper, silver or gold. When the inter-ribbon 142 is formed of copper as a main metal, the inter-ribbon 142 may achieve excellent electrical conductivity, physical properties, and reflectance with low material costs. In addition, the solder layer 1424 may be formed of a material, which may be disposed on the inter-ribbon body 1420 and be adhesively attached to the solar cells 150 so as to electrically connect the inter-ribbon 142 and the electrodes 42 and 44 of the solar cells 150 to each other. For example, the solder layer 1424 may include tin (Sn), and may further include various other metals. In one example, the solder layer 1424 may include tin in an amount of 30 to 100 wt%, and may further include lead (Pb) in an amount of 0 to 50 wt%, silver (Ag) in an amount of 0 to 20 wt%, bismuth (Bi) in an amount of 0 to 60 wt%, zinc (Zn) in an amount of 0 to 60 wt%, and copper (Cu) in an amount of 0 to 50 wt%. While this composition of the solder layer 1424 is proposed in order to improve the attachment between the inter-ribbon body 1420 and the solar cells 150, the present inventive concept is not limited thereto. Accordingly, the composition of the solder layer 1424 may be changed in various ways.

In the present embodiment, a first area A1 and a second area A2 may be defined in one side (e.g. the front surface) of the inter-ribbon body 1420. The first area A1 corresponds to an area that is attached to the first solar cell (see reference numeral 151 in FIG. 9), and the second area A2 is the remaining area excluding the first area A1. More specifically, the first area A1 in the front surface of the inter-ribbon body 1420 may refer to an area that is attached or fixed to the back surface of the first solar cell 151 (i.e. to the second electrode 44 of the first solar cell 151), and the second area A2 in the front surface of the inter-ribbon body 1420 may refer to the remaining area excluding the first area A1. The second area A2 may include a first area portion A21, which is attached or fixed above the first electrode 42 of the second solar cell 152, and a second area portion A22, which is located between the second electrode 44 of the first solar cell 151 and the first electrode 42 of the second solar cell 152 so as to connect the first area A1 and the first area portion A21 to each other.

Here, on the front surface of the inter-ribbon body 1420, the solder layer 1424 may be disposed in the first area A1 and the black layer 1422 may be disposed in the second area A2. In addition, the solder layer 1424 is disposed throughout the other side (e.g. the back surface) of the inter-ribbon body 1420.

In the present embodiment, the inter-ribbon 142 may take the form of a strip or bar having a width smaller than the width of the solar cell 150. More specifically, the inter-ribbon 142 may have an elongated shape so as to have a width corresponding to the bus-bar electrode (see reference numeral 44b in FIG. 4) of the second electrode 44 of the first solar cell 151 and the bus-bar electrode (see reference numeral 42b in FIG. 4) of the first electrode 42 of the second solar cell 152. As such, the inter-ribbon 142 may extend a long length from one end of the second electrode 44 of the first solar cell 151, which is located distant from the second solar cell 152, to the other end of the second electrode 44 along the bus-bar electrode 44b so as to correspond to (or to be superposed on) the bus-bar electrode 44b of the second electrode 44, and thereafter, may extend to one end of the first electrode 42 of the second solar cell 152, which is located close to the first solar cell 151, and thereafter may again extend from the end of the first electrode 42 of the second solar cell 152, which is located close to the first solar cell 151, to the other end of the first electrode 42 along the bus-bar electrode 42b so as to correspond to (or to be superposed on) the bus-bar electrode 42b of the first electrode 42. In this way, the inter-ribbon 142 may cross the first solar cell 151 in an area of the first solar cell 151, and thereafter may cross the second solar cell 152 in an area of the second solar cell 152. Because the inter-ribbon 142 is formed only in the portion corresponding to the first and second electrodes 42 and 44 of the first and second solar cells 151 and 152 (in particular, the bus-bar electrodes 42b and 44b) as described above, the inter-ribbon 142 may effectively interconnect the first and second solar cells 151 and 152 despite a small area thereof. When the first and second electrodes 42 and 44 do not include the bus-bar electrodes 42b and 44b, the inter-ribbon 142 may be located so as to cross the finger electrodes (see reference numerals 42a and 44a in FIG. 4).

When each solar cell 150 includes multiple first or second electrodes 42 or 44 (in particular, multiple bus-bar electrodes 42b or 44b), the inter-ribbon 142 may be provided in a plural number corresponding thereto.

As described above, the first area A1 on the front surface of the inter-ribbon 142 is attached to the second electrode 44 by a first solder layer 1424a, which is disposed below the second electrode 44 of the first solar cell 151, and the first area portion A21 on the back surface of the inter-ribbon 142 is attached to the first electrode 42 by a second solder layer 1424b, which is located above the first electrode 42 of the second solar cell 152. At this time, when heat and pressure are applied in the state in which the first area A1 of the inter-ribbon 142 is placed on the second electrode 44 of the first solar cell 151, the second electrode 44 of the first solar cell 151 and the first area A1 of the inter-ribbon 142 may be attached to each other by the first solder layer 1424a. Similarly, when heat and pressure are applied in the state in which the second area A2 (in particular, the first area portion A21) of the inter-ribbon 142 is placed on the first electrode 42 of the second solar cell 152, the first electrode 42 of the second solar cell 152 and the second area A2 of the inter-ribbon 142 may be attached to each other by the second solder layer 1424b.

At this time, the second area A2 on the front surface of the inter-ribbon 142 may be located between the first solar cell 151 and the second solar cell 152 and located over the front surface of the second solar cell 152. Because the second area A2, which is exposed to the front side, is covered with the black layer 1422, it is possible to prevent the inter-ribbon 142 from being perceived from the outside. Because the solder layer 1424 is formed throughout the longitudinal surfaces of the inter-ribbon body 1420 in the entire portion excluding the black layer 1422, oxidation of the inter-ribbon body 1420 may be effectively prevented.

Both the black layer 1422 and the solder layer 1424 may be disposed on either longitudinal side surface of the inter-ribbon 142. More specifically, the solder layer 1424 may be formed throughout the portion, corresponding to the first area A1, on the side surface of the inter-ribbon 142. In addition, the remaining portion, corresponding to the second area A2, on the side surface of the inter-ribbon 142 may be divided into a portion close to the front surface, in which the black layer 1422, formed on the front surface, extends from the front surface, and the remaining portion in which the solder layer 1424 is located. With respect to the area of each side surface corresponding to the second area A2, the area of the black layer 1422 may range from 30% to 70%, and more particularly, may range from 40% to 60%. Likewise, the area of the solder layer 1424 may range from 30% to 70%, and more particularly, may range from 40% to 60%. However, the present inventive concept is not limited thereto, and various alterations are possible.

An additional description related to the inter-ribbon body 1420, the black layer 1422 and the solder layer 1424 of the inter-ribbon 142 may be replaced with the description related to the bus-ribbon body 1450, the black layer 1452 and the solder layer 1454 of the bus ribbon 144. In addition, the manufacturing method of the inter-ribbon 142 is the same as the manufacturing method of the bus ribbon 145 except that the black layer 1422 is formed in a portion of the front surface of the inter-ribbon body 1420.

Accordingly, the inter-ribbon 142 according to the present embodiment includes the black layer 1422 on a portion of the inter-ribbon body 1420, which is exposed to the front side, thereby preventing the inter-ribbon 142 from being perceived from the outside. In addition, the black layer 1422 having an insulation property is located on the front surface of the inter-ribbon 142, which is regardless of the electrical connection and attachment of the solar cell 150, which may further increase the insulation of the solar cell panel 100.

In the present inventive concept, only one of the bus-ribbon 145 and the inter-ribbon 142 having the above-described structure may be provided, and both the bus-ribbon 145 and the inter-ribbon 142 may be provided.

As is apparent from the above description, in a ribbon and a solar cell panel including the same according to the embodiments, the ribbon including a black layer may improve the external appearance and insulation of the solar cell panel. In addition, through a method of manufacturing the ribbon according to the embodiments may allow the ribbon, which includes a black layer and a solder layer, to be formed into a desired pattern via a simplified process.

## Claims

1. A ribbon (142, 145) for a solar cell panel, the ribbon comprising:
a ribbon body (1420, 1450) having electrical conductivity;
an insulating layer (1422, 1452) disposed on at least one side over a longitudinal surface of at least the ribbon body; and
a solder layer (1424, 1454) disposed throughout a portion excluding the insulating layer over the longitudinal surface of the ribbon body, the solder layer being disposed throughout at least a remaining side opposite to the one side,
**characterized in that** each of the insulating layer and the solder layer is formed in an area ranging from 30% to 70% of a side surface, connecting the one side and the remaining side to each other, in a longitudinal direction of the ribbon body.

2. The ribbon (142, 145) according to claim 1, wherein the insulating layer (1422, 1452) has one surface coming into contact with the ribbon body (1420, 1450) and a remaining surface configuring one outer surface of the ribbon body, and
wherein the solder layer (1424, 1454) has one surface coming into contact with the ribbon body and a remaining surface configuring another outer surface of the ribbon body.

3. The ribbon (142, 145) according to claim 1 or 2, wherein the insulating layer is black or gray.

4. The ribbon (142, 145) according to any one preceding claim, wherein the insulating layer (1422, 1452) includes a resin and a black material, and
wherein the black material includes carbon black.

5. A method of manufacturing a ribbon for a solar cell panel, the method comprising:
forming an insulating layer, including a resin and a black material, on a portion of a ribbon body; and
forming a solder layer throughout a remaining portion of the ribbon body excluding the insulating layer by immersing the ribbon body, having the insulating layer formed thereon, in a solder material.

6. The method according to claim 5, wherein, in the forming the insulating layer, the insulating layer is formed by dispensing and curing an ink including the resin and the black material.

7. The method according to claim 5 or 6, wherein the black material includes carbon black.

8. The method according to claim 6 or 7, wherein the ink further includes a thermal curing agent,
wherein the resin includes a thermosetting organic binder, and
wherein the ink is cured by thermal curing.

9. The method according to any one of claims 5 to 8, wherein the solder material includes at least one metal including tin (Sn) as a main component, and
wherein wettability of the solder material with respect to the insulating layer is less than wettability of the solder material with respect to the ribbon body.

10. The method according to any one of claims 5 to 9, wherein the ribbon for the solar cell panel includes an inter-ribbon for interconnecting two neighboring solar cells,
wherein the insulating layer is disposed in a portion on one side of the ribbon body, and
wherein the solder layer is disposed throughout a remaining portion excluding the insulating layer on the one side, the solder layer being disposed throughout a remaining side opposite to the one side.

11. A solar cell panel comprising:
a plurality of solar cell strings formed by electrically connecting a plurality of solar cells (150) to each other;
a bus ribbon (145) for electrically connecting the solar cell strings to each other or for electrically connecting the solar cell strings to an external circuit;
a protective front substrate (110) disposed on a front surface of the solar cells;
a protective back substrate (120) disposed on a back surface of the solar cells; and
an encapsulation layer disposed between the protective front substrate, the protective back substrate, and the solar cells,
wherein the bus ribbon includes:
a bus-ribbon body (1450);
an insulating layer (1452) disposed on at least one side, facing the protective front substrate, over a longitudinal surface of at least the bus-ribbon body; and
a solder layer (1454) disposed on at least a remaining side, facing the solar cell strings, over the longitudinal surface of the bus-ribbon body, and
**characterized in that** each of the insulating layer and the solder layer is formed by a range from 30% to 70% on a side surface of the longitudinal surface of the bus-ribbon body, the side surface connecting the one side of the bus-ribbon body facing the protective front substrate and the remaining side of bus-ribbon body facing the solar cell strings to each other.

12. The solar cell panel according to claim 11, wherein the insulating layer (1452) is disposed throughout a front surface of the bus-ribbon body (1450).

13. A solar cell panel comprising:
a plurality of solar cells;
an inter-ribbon (142) for electrically interconnecting the solar cells;
a protective front substrate disposed on a front surface of the solar cells;
a protective back substrate disposed on a back surface of the solar cells; and
an encapsulation layer disposed between the protective front substrate, the protective back substrate, and the solar cells,
wherein the inter-ribbon includes:
a ribbon body (1420) having a first surface in a longitudinal direction, a second surface opposite to the first surface, and a side surface connecting the first surface and the second surface to each other;
an insulating layer (1422) disposed on at least a second area (A2), facing the protective front substrate, of the first surface of the ribbon body;
a first solder layer (1424a) disposed on a first area (A1) of the first surface of the ribbon body located close to the solar cells; and
a second solder layer (1424b) disposed on at least an area of the second surface of the ribbon body located close to the solar cells,
wherein each of the insulating layer and the solder layer is formed on either side surface of the ribbon body by a range from 30% to 70%.

14. The solar cell panel according to claim 13, wherein the second area (A2) includes an area fixed on the solar cells (150) and an area located between the solar cells, and is longer than the first area.

15. The solar cell panel according to claim 13 or 14, wherein the second solder layer (1424b) is formed throughout the second surface of the ribbon body (1420).

## Patentansprüche

1. Band (142, 145) für ein Solarzellenpaneel, wobei das Band umfasst:
einen Bandkörper (1420, 1450), der elektrische Leitfähigkeit aufweist;
eine isolierende Schicht (1422, 1452), welche auf mindestens einer Seite über einer Längsfläche zumindest des Bandkörpers angeordnet ist; und
eine Lötschicht (1424, 1454), welche durchgehend in einem Bereich, ausgenommen die isolierende Schicht über der Längsfläche des Bandkörpers angeordnet ist,
wobei die Lötschicht durchgehend zumindest auf einer verbleibenden Seite, welche zu der einen Seite entgegengesetzt ist, angeordnet ist,
**dadurch gekennzeichnet, dass** sowohl die isolierende Schicht als auch die Lötschicht in einem Bereich gebildet sind, welcher 30% bis 70% einer die eine Seite und die verbleibende Seite miteinander verbindenden Seitenfläche in einer Längsrichtung des Bandkörpers ausmacht.

2. Band (142, 145) nach Anspruch 1, wobei die isolierende Schicht (1422, 1452) eine Fläche, welche mit dem Bandkörper (1420, 1450) in Kontakt steht, und eine verbleibende Fläche aufweist, welche eine äußere Fläche des Bandkörpers darstellt, und wobei die Lötschicht (1424, 1454) eine Fläche, welche mit dem Bandkörper in Kontakt steht, und eine verbleibende Fläche aufweist, welche eine äußere Fläche des Bandkörpers darstellt.

3. Band (142, 145) nach Anspruch 1 oder 2, wobei die isolierende Schicht schwarz oder grau ist.

4. Band (142, 145) nach einem beliebigen vorhergehenden Anspruch, wobei die isolierende Schicht (1422, 1452) ein Harz und ein schwarzes Material umfasst, und wobei das schwarze Material Ruß enthält.

5. Verfahren zum Herstellen eines Bands für ein Solarzellenpaneel, wobei das Verfahren umfasst:
Bilden einer isolierenden Schicht, welche ein Harz und ein schwarzes Material enthält, auf einem Teil eines Bandkörpers;
Bilden einer Lötschicht durchgehend in einem verbleibenden Abschnitt des Bandkörpers ausgenommen die isolierende Schicht, durch Eintauchen des Bandkörpers mit der darauf gebildeten isolierenden Schicht in ein Lötmaterial.

6. Verfahren nach Anspruch 5, wobei während der Bildung der isolierenden Schicht die isolierende Schicht durch Verteilen und Aushärten einer Tinte, welche das Harz und das schwarze Material enthält, gebildet wird.

7. Verfahren nach Anspruch 5 oder 6, wobei das schwarze Material Ruß enthält.

8. Verfahren nach Anspruch 6 oder 7, wobei die Tinte des Weiteren ein thermisch aushärtendes Mittel enthält, wobei das Harz ein wärmehärtendes organisches Bindemittel enthält, und wobei die Tinte durch thermisches Aushärten ausgehärtet wird.

9. Verfahren nach einem beliebigen der Ansprüche 5 bis 8, wobei das Lötmaterial mindestens ein Metall enthält, welches Zinn (Sn) als eine Hauptkomponente enthält, und wobei die Benetzbarkeit des Lötmaterials in Bezug auf die isolierende Schicht geringer ist als die Benetzbarkeit des Lötmaterials in Bezug auf den Bandkörper.

10. Verfahren nach einem der Ansprüche 5 bis 9, wobei das Band für das Solarzellenpaneel ein Zwischenband zum Verbinden zweier benachbarter Solarzellen enthält,
wobei die isolierende Schicht in einem Abschnitt auf einer Seite des Bandkörpers angeordnet wird, und
wobei die Lötschicht auf der einen Seite durchgehend in einem verbleibenden Abschnitt ausgenommen die isolierende Schicht angeordnet wird, wobei die Lötschicht durchgehend auf einer verbleibenden Seite, welche zu der einen Seite entgegengesetzt ist, angeordnet wird.

11. Solarzellenpaneel umfassend:
eine Mehrzahl von Solarzellenreihen, welche durch elektrisches Verbinden einer Mehrzahl von Solarzellen (150) gebildet sind;
ein Sammelschienenband (145) zum elektrischen Verbinden der Solarzellenreihen miteinander oder zum elektrischen Verbinden der Solarzellenreihen mit einem externen Kreislauf;
ein vorderes Schutzsubstrat (110), welches auf einer Vorderseite der Solarzellen angeordnet ist;
ein rückseitiges Schutzsubstrat (120), welches auf einer Rückseite der Solarzellen angeordnet ist; und
eine Kapselungsschicht, welche zwischen dem vorderen Schutzsubstrat, dem rückseitigen Schutzsubstrat und den Solarzellen angeordnet ist,
wobei das Sammelschienenband enthält:
einen Sammelschienenbandkörper (1450);
eine isolierende Schicht (1452), welche auf mindestens einer Seite, welche dem vorderen Schutzsubstrat zugewandt ist, über einer Längsfläche zumindest des Sammelschienenbandkörpers angeordnet ist; und
eine Lötschicht (1454), welche zumindest auf einer verbleibenden Seite, welche den Solarzellenreihen zugewandt ist, über der Längsfläche des Sammelschienenbandkörpers angeordnet ist; und
**dadurch gekennzeichnet, dass** sowohl die isolierende Schicht als auch die Lötschicht in einem Bereich gebildet sind, welcher 30% bis 70% einer Seitenfläche der Längsfläche des Sammelschienenbandkörpers ausmacht, wobei die Seitenfläche die eine Seite des Sammelschienenbandkörpers, welche dem vorderen Schutzsubstrat zugewandt ist, und die verbleibende Seite des Sammelschienenbandkörpers, welche den Solarzellenreihen zugewandt ist, miteinander verbindet.

12. Solarzellenpanel nach Anspruch 11, wobei die isolierende Schicht (1452) durchgehend über eine Vorderseite des Sammelschienenbandkörpers (1450) angeordnet ist.

13. Solarzellenpaneel umfassend:
eine Mehrzahl von Solarzellen;
ein Zwischenband (124) zum elektrischen Verbinden der Solarzellen;
ein vorderes Schutzsubstrat, welches auf einer Vorderseite der Solarzellen angeordnet ist;
ein rückseitiges Schutzsubstrat, welches auf einer Rückseite der Solarzellen angeordnet ist; und
eine Kapselungsschicht, welche zwischen dem vorderen Schutzsubstrat, dem rückseitigen Schutzsubstrat und den Solarzellen angeordnet ist,
wobei das Zwischenband enthält:
einen Bandkörper (1420) mit einer ersten Fläche in einer Längsrichtung, einer zweiten Fläche, welche zu der ersten Fläche entgegengesetzt ist, und einer die erste Fläche und die zweite Fläche miteinander verbindende Seitenfläche;
eine isolierende Schicht (1422), welche zumindest in einem dem vorderen Schutzsubstrat der ersten Fläche des Bandkörpers zugewandten zweiten Gebiet (A2) angeordnet ist;
eine erste Lötschicht (1424a), welche in einem ersten Gebiet (A1) der ersten Fläche des Bandkörpers nahe zu den Solarzellen angeordnet ist; und
eine zweite Lötschicht (1424b), welche mindestens in einem Gebiet der zweiten Fläche des Bandkörpers nahe zu den Solarzellen angeordnet ist,
wobei sowohl die isolierende Schicht als auch die Lötschicht auf jeder Seitenfläche des Bandkörpers in einem Bereich gebildet sind, der 30% bis 70% ausmacht.

14. Solarzellenpanel nach Anspruch 13, wobei das zweite Gebiet (A2) ein auf den Solarzellen (150) feststehendes Gebiet und ein zwischen den Solarzellen angeordnetes Gebiet enthält und länger ist als das erste Gebiet.

15. Solarzellenpanel nach Anspruch 13 oder 14, wobei die zweite Lötschicht (1424b) durchgehend über die zweite Fläche des Bandkörpers (1420) gebildet ist.

## Revendications

1. Ruban (142, 145) pour un panneau de cellules solaires, le ruban comprenant :
un corps de ruban (1420, 1450) ayant une conductivité électrique ;
une couche isolante (1422, 1452) disposée sur au moins un côté sur une surface longitudinale d'au moins le corps de ruban ; et
une couche de soudure (1424, 1454) disposée dans toute une partie à l'exclusion de la couche isolante sur la surface longitudinale du corps de ruban, la couche de soudure étant disposée sur au moins un côté restant, opposé au premier côté,
**caractérisé en ce que** chacune de la couche isolante et de la couche de soudure est formée dans une zone allant de 30 % à 70 % d'une surface latérale, reliant un côté et le côté restant l'un à l'autre, dans une direction longitudinale du corps de ruban.

2. Ruban (142, 145) selon la revendication 1, dans lequel la couche isolante (1422, 1452) a une surface venant en contact avec le corps de ruban (1420, 1450) et une surface restante configurant une surface externe du corps de ruban, et
dans lequel la couche de soudure (1424, 1454) a une surface venant en contact avec le corps de ruban et une surface restante configurant une autre surface externe du corps de ruban.

3. Ruban (142, 145) selon la revendication 1 ou 2, dans lequel la couche isolante est noire ou grise.

4. Ruban (142, 145) selon l'une quelconque des revendications précédentes, dans lequel la couche isolante (1422, 1452) comprend une résine et un matériau noir, et
dans lequel le matériau noir comprend du noir de carbone.

5. Procédé de fabrication d'un ruban pour un panneau de cellules solaires, le procédé comprenant :
la formation d'une couche isolante, comprenant une résine et un matériau noir, sur une partie d'un corps de ruban ; et
la formation d'une couche de soudure dans toute une partie restante du corps de ruban à l'exclusion de la couche isolante par immersion du corps de ruban, ayant la couche isolante formée sur celui-ci, dans un matériau de soudure.

6. Procédé selon la revendication 5, dans lequel, dans la formation de la couche isolante, la couche isolante est formée en distribuant et en durcissant une encre comprenant la résine et le matériau noir.

7. Procédé selon la revendication 5 ou 6, dans lequel le matériau noir comprend du noir de carbone.

8. Procédé selon la revendication 6 ou 7, dans lequel l'encre comprend en outre un agent de durcissement thermique,
dans lequel la résine comprend un liant organique thermodurcissable, et
dans lequel l'encre est durcie par durcissement thermique.

9. Procédé selon l'une quelconque des revendications 5 à 8, dans lequel le matériau de soudure comprend au moins un métal comprenant de l'étain (Sn) en tant que constituant principal, et
dans lequel la mouillabilité du matériau de soudure par rapport à la couche isolante est inférieure à la mouillabilité du matériau de soudure par rapport au corps de ruban.

10. Procédé selon l'une quelconque des revendications 5 à 9, dans lequel le ruban pour le panneau de cellules solaires comprend un inter-ruban pour interconnecter deux cellules solaires voisines,
dans lequel la couche isolante est disposée dans une partie d'un côté du corps de ruban, et
dans lequel la couche de soudure est disposée dans toute une partie restante à l'exclusion de la couche isolante sur ce côté, la couche de soudure étant disposée sur tout un côté restant, opposé au premier côté.

11. Panneau de cellules solaires comprenant :
une pluralité de chaînes de cellules solaires formées en connectant électriquement une pluralité de cellules solaires (150) les unes aux autres ;
un ruban de bus (145) pour connecter électriquement les chaînes de cellules solaires les unes aux autres ou pour connecter électriquement les chaînes de cellules solaires à un circuit externe ;
un substrat de protection avant (110) disposé sur une surface avant des cellules solaires ;
un substrat de protection arrière (120) disposé sur une surface arrière des cellules solaires ; et
une couche d'encapsulation disposée entre le substrat de protection avant, le substrat de protection arrière et les cellules solaires,
dans lequel le ruban de bus comprend :
un corps de ruban de bus (1450) ;
une couche isolante (1452) disposée sur au moins un côté, face au substrat de protection avant, sur une surface longitudinale d'au moins le corps de ruban de bus ; et
une couche de soudure (1454) disposée sur au moins un côté restant, face aux chaînes de cellules solaires, sur la surface longitudinale du corps de ruban de bus, et
**caractérisé en ce que** chacune de la couche isolante et de la couche de soudure est formée dans une plage de 30 % à 70 % sur une surface latérale de la surface longitudinale du corps de ruban de bus, la surface latérale reliant un côté du corps de ruban de bus faisant face au substrat de protection avant et le côté restant du corps de ruban de bus faisant face aux chaînes de cellules solaires l'un à l'autre.

12. Panneau de cellules solaires selon la revendication 11, dans lequel la couche isolante (1452) est disposée dans toute une surface avant du corps de ruban de bus (1450).

13. Panneau de cellules solaires comprenant :
une pluralité de cellules solaires ;
un inter-ruban (142) pour interconnecter électriquement les cellules solaires ;
un substrat de protection avant disposé sur une surface avant des cellules solaires ;
un substrat de protection arrière disposé sur une surface arrière des cellules solaires ; et
une couche d'encapsulation disposée entre le substrat de protection avant, le substrat de protection arrière et les cellules solaires,
dans lequel l'inter-ruban comprend :
un corps de ruban (1420) ayant une première surface dans une direction longitudinale, une deuxième surface opposée à la première surface et une surface latérale reliant la première surface et la deuxième surface l'une à l'autre ;
une couche isolante (1422) disposée sur au moins une deuxième zone (A2), faisant face au substrat de protection avant, de la première surface du corps de ruban ;
une première couche de soudure (1424a) disposée sur une première zone (A1) de la première surface du corps de ruban située à proximité des cellules solaires ; et
une seconde couche de soudure (1424b) disposée sur au moins une zone de la deuxième surface du corps de ruban située à proximité des cellules solaires,
dans lequel chacune de la couche isolante et de la couche de soudure est formée sur chaque surface latérale du corps de ruban dans une plage de 30 % à 70 %.

14. Panneau de cellules solaires selon la revendication 13, dans lequel la seconde zone (A2) comprend une zone fixée sur les cellules solaires (150) et une zone située entre les cellules solaires, et est plus longue que la première zone.

15. Panneau de cellules solaires selon la revendication 13 ou 14, dans lequel la seconde couche de soudure (1424b) est formée dans toute la deuxième surface du corps de ruban (1420).
